# EUROPEAN PATENT SPECIFICATION

(11) **EP 0 486 985 B1**
(45) Date of publication and mention of the grant of the patent: **05.03.1997**
(21) Application number: 91119630.1
(22) Date of filing: 18.11.1991
(51) Int. Cl.: G01R 19/165

(54) **Comparator**
Komparator
Comparateur

(30) Priority: 19.11.1990 JP 311278/90
(43) Date of publication of application: 27.05.1992
(73) Proprietor: CANON KABUSHIKI KAISHA, Tokyo (JP)
(72) Inventor: Matsuno, Yasushi, c/o Canon Kabushiki Kaisha, Ohta-ku, Tokyo 146 (JP)
(74) Representative: Pellmann, Hans-Bernd, Dipl.-Ing.

(56) References cited:
- GB-A- 2 062 996
- US-H-t957008 (RCA)
- EDN vol. 32, no. 15, July 1987, NEWTON,US pages 309 - 310; HILL: 'Audio AGC circuit has 40-dB dynamic range'
- U. Tietze, Ch. Schenk "Halbleiter-Schaltungstechnik", 10th. edition, Springer-Verlag, pages 66-67

## Description

### BACKGROUND OF THE INVENTION

### Field of the Invention

The invention relates to a comparator.

### Related Background Art

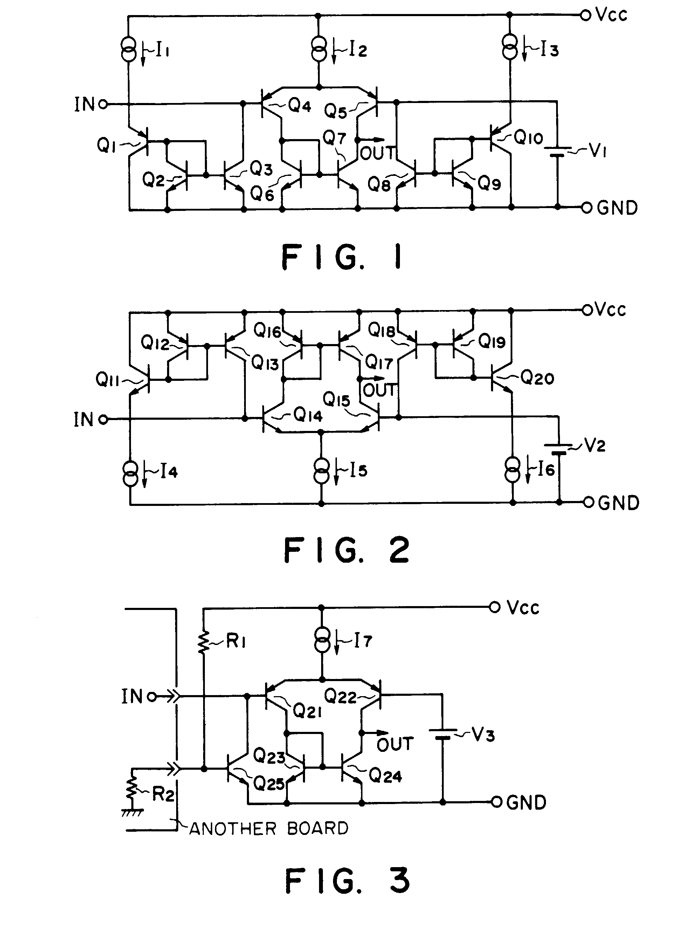

Fig. 3 shows an example of a circuit of a conventional comparator. V₃ denotes a reference voltage source; I₇ indicates a constant current source; Q₂₁ to Q₂₅ transistors; and R₁ and R₂ resistors.

A circuit which is constructed by the constant current source I₇ and the transistors Q₂₁ to Q₂₄ is a simple comparator. An input terminal IN and the resistor R₂ are connected to a base of the transistor Q₂₁ and a base of the transistor Q₂₅ through wires and connectors from another electronic circuit board, respectively.

The operation of the comparator of Fig. 3 will now be described hereinbelow.

In the case where the input terminal IN and the resistor R₂ are respectively connected to the above transistors Q₂₁ and Q₂₅, the transistor Q₂₅ is turned off and the circuit operates as an ordinary comparator.

When the terminal IN and the resistor R₂ are not connected, an output of the comparator is an output in a state in which a high level signal has been applied to an input. In this state, if a problem logically occurs, the transistor Q₂₅ connected by the resistor R₁ is set into a saturation state by a power source V_{cc}, thereby fixing a base potential of the transistor Q₂₁ to a low level and satisfying the logic.

The conventional comparator, however, has the following technical problems to be solved.
(1) Since the wires or connectors must be added to know the coupling state, the costs rise.
(2) Since the wires or connectors are needed to know the coupling state in addition to a purpose of the input of the comparator, it is impossible to know the coupling states of both of them. If then a disconnection to each wire or a damage of the connector occurs, the normal operation cannot be performed and there is a fear of malfunction.

### SUMMARY OF THE INVENTION

It is an object of the invention to provide a comparator which can solve the foregoing problems.

According to the present invention this object is achieved by a comparator for turning on/off an input terminal, comprising a first constant current source; a differential amplifier connected to said first constant current source; a first current mirror circuit connected to said differential amplifier; second and third current mirror circuits connected to both sides of said differential amplifier and said first current mirror circuit, respectively; said first, second and third current mirror circuits comprising transistors; and second and third constant current sources connected to both sides of said second and third current mirror circuits, respectively; said second current mirror circuit and said second constant current source constituting a control circuit to enable the transistor of said second current mirror circuit connected to said differential amplifier in a high impedance input state.

According to the invention, the high impedance input state can be detected by the above construction without additionally providing any wire and connector.

The advantages of the invention will become apparent and obvious to those skilled in the pertinent art upon referring to the following description provided in connection with the accompanying drawings.

### BRIEF DESCRIPTION OF THE DRAWINGS

Fig. 1 is a circuit diagram of a comparator according to an embodiment of the invention;
Fig. 2 is a circuit diagram of a comparator according to another embodiment of the invention; and
Fig. 3 is a circuit diagram of a conventional comparator.

### DETAILED DESCRIPTION OF THE PREFERRED EMBODIMENTS

Fig. 1 is a circuit constructional diagram showing most preferably a feature of the invention. In Fig. 1, V₁ denotes a reference voltage source; I₁ to I₃ indicate constant current sources; and Q₁ to Q₁₀ indicate transistors.

A circuit which is constructed by the constant current source I₂ and the transistors Q₄ to Q₇ is a comparator. Current mirror circuits are constructed by the transistors Q₂ and Q₃ and the transistors Q₈ and Q₉. The constant current source I₁ and the transistor Q₁ supply a constant current to the current mirror circuit. The constant current source I₃ and the transistor Q₁₀ supply a constant current to the current mirror circuit.

It is now assumed that the transistors Q₁, Q₄, Q₅, and Q₁₀ are equal PNP transistors and that the transistors Q₂, Q₃, Q₈, and Q₉ are equal NPN transistors. There are the relations of I₁ = I₃ and I₁ > I₂ among the constant current sources I₁ to I₃.

The operation of the comparator of Fig. 1 will now be described hereinbelow.

In the case where some input exists at the input terminal IN which is connected to a base of the transistor Q₄, a collector of the transistor Q₃ pulls in a current which is equivalent to a base current of the transistor Q₁ from the base of the transistor Q₄ and the terminal IN. At this time, the circuit operates as an ordinary comparator.

The operation in a disconnected state of the input terminal IN, which is a problem in the conventional comparator, in the case of the embodiment will now be described. When no input exists at the input terminal IN, the collector of the transistor Q₃ tries to pull in all of the currents which are equivalent to the base current of the transistor Q₁, from the base of the transistor Q₄. Since the relation between the constant current sources I₁ and I₂ is now set to I₁ > I₂, the base current of the transistor Q₁ = the collector current of the transistor Q₃ and the collector current of the transistor Q₃ > the base current of the transistor Q₄, so that the transistor Q₃ is set into the saturating state. A base potential of the transistor Q₄, therefore, is determined by a voltage between the collector and the emitter of the transistor Q₃ and is fixed to a low level.

Fig. 2 is a circuit constructional diagram showing another embodiment of the invention. In Fig. 2, V₂ denotes a reference voltage source; I₄ to I₆ constant current sources; and Q₁₁ to Q₂₀ transistors.

A circuit which is constructed by the constant current source I₅ and the transistors Q₁₄ to Q₁₇ is a comparator. Current mirror circuits are constructed by the transistors Q₁₂ and Q₁₃ and the transistors Q₁₈ and Q₁₉. The constant current source I₄ and the transistor Q₁₁ function as a constant current source which is supplied to the current mirror circuit. The constant current source I₆ and the transistor Q₂₀ function as a constant current source which is supplied to the current mirror circuit.

It is now assumed that the transistors Q₁₁, Q₁₄, Q₁₅, and Q₂₀ are equal NPN transistors and that the transistors Q₁₂, Q₁₃, Q₁₈, and Q₁₉ are equal PNP transistors. There are the relations of I₄ = I₆ and I₄ > I₅ among the constant current sources I₄ to I₆.

The operation of the comparator of Fig. 2 will now be described hereinbelow.

In the case where some input exists at the input terminal IN which is connected to a base of the transistor Q₁₄, a collector of the transistor Q₁₃ supplies a current which is equivalent to a base current of the transistor Q₁₁ to the base of the transistor Q₁₄ and the terminal IN. At this time, the circuit operates as an ordinary comparator.

In the case where no input exists at the input terminal IN, which becomes a problem in the conventional comparator, the collector of the transistor Q₁₃ tries to supply all of the currents equivalent of the base current of the transistor Q₁₁ to the base of the transistor Q₁₄. Since the relation between the constant current sources I₄ and I₅ is set to I₄ > I₅ , the base current of the transistor Q₁₁ = the collector current of the transistor Q₃ and the collector current of the transistor Q₃ the base current of the transistor Q₁₄, so that the transistor Q₁₃ is set into the saturating state. Therefore, the base potential of the transistor Q₁₄ is determined by the voltage between the collector and the emitter of the transistor Q₁₃ and is fixed to a high level.

As described above, according to the embodiments, since none of the wires and connectors is additionally needed, the input disconnection state can be certainly known without increasing the costs.

## Claims

1. A comparator for turning on/off an input terminal (IN), comprising
a first constant current source (I₂; I₅);
a differential amplifier (Q₄, Q₅; Q₁₄, Q₁₅) connected to said first constant current source (I₂; I₅);
a first current mirror circuit (Q₆, Q₇; Q₁₆, Q₁₇) connected to said differential amplifier (Q₄, Q₅; Q₁₄, Q₁₅);
second and third current mirror circuits (Q₂, Q₃, Q₈, Q₉; Q₁₂, Q₁₃, Q₁₈, Q₁₉) connected to both sides of said differential amplifier (Q₄, Q₅; Q₁₄, Q₁₅) and said first current mirror circuit (Q₆, Q₇; Q₁₆, Q₁₇), respectively;
said first, second and third current mirror circuits (Q₆, Q₇, Q₂, Q₃, Q₈, Q₉;Q₁₆, Q₁₇, Q₁₂, Q₁₃, Q₁₈, Q₁₉) comprising transistors; and
second and third constant current sources (I₁, Q₁, I₃, Q₁₀; I₄, Q₁₁, I₆, Q₂₀) connected to both sides of said second and third current mirror circuits (Q₂, Q₃, Q₈, Q₉; Q₁₂, Q₁₃, Q₁₈, Q₁₉), respectively;
said second current mirror circuit (Q₂, Q₃; Q₁₂, Q₁₃), and said second constant current source (I₁, Q₁; I₄, Q₁₁) constituting a control circuit (Q₁, Q₂, Q₃, I₁; Q₁₁, Q₁₂, Q₁₃, I₄) to enable the transistor of said second current mirror circuit (Q₂, Q₃, Q₁₂, Q₁₃) connected to said differential amplifier (Q₄, Q₅; Q₁₄, Q₁₅) in a high impedance input state.

2. A comparator according to claim 1, wherein
said differential amplifier (Q₄, Q₅; Q₁₄, Q₁₅) comprises a pair of transistors (Q₄, Q₅; Q₁₄, Q₁₅) connected to said input terminal (IN) to which an input signal is supplied and to an output terminal (OUT) for supplying an output signal, a base of one (Q₄; Q₁₄) of said pair of transistors (Q₄, Q₅; Q₁₄, Q₁₅) being connected to said input terminal IN and a collector of the other (Q₅; Q₁₅) of said pair of transistors (Q₄, Q₅; Q₁₄, Q₁₅) being connected to said output terminal (OUT); and
said control circuit (Q₁, Q₂, Q₃, I₁; Q₁₁, Q₁₂, Q₁₃, I₄) is connected to said input terminal (IN) for controlling a potential of said input terminal (IN) responsive to a high impedance condition of said input terminal (IN);
said third current mirror circuit (Q₈, Q₉; Q₁₈, Q₁₉), and said third constant current source (I₃, Q₁₀; I₆, Q₂₀) constituting a further control circuit (Q₈, Q₉, Q₁₀, I₃; Q₁₈, Q₁₉, Q₂₀, I₆) being identical with said control circuit (Q₁, Q₂, Q₃, I₁; Q₁₁, Q₁₂, Q₁₃, I₄), and being connected to said other (Q₅; Q₁₅) of said pair of transistors (Q₄, Q₅; Q₁₄, Q₁₅) connected to said output terminal (OUT).

3. A comparator according to claim 1 or 2, wherein each of said second and third constant current sources (I₁, Q₁, I₃, Q₁₀; I₄, Q₁₁, I₆, Q₂₀) comprises a current source (I₁, I₃; I₄, I₆) and a further transistor (Q₁, Q₁₀; Q₁₁, Q₂₀) for supplying a current to said second and third current mirror circuit (Q₂, Q₃, Q₈, Q₉; Q₁₂, Q₁₃, Q₁₈, Q₁₉₎, respectively.

## Patentansprüche

1. Komparator zum Ein-/Ausschalten eines Eingangsanschlusses (IN) mit
einer ersten Konstantstromquelle (I₂; I₅),
einem an die erste Konstantstromquelle (I₂; I₅) angeschlossenen Differenzverstärker (Q₄, Q₅; Q₁₄, Q₁₅),
einer an den Differenzverstärker (Q₄, Q₅; Q₁₄, Q₁₅) angeschlossenen ersten Stromspiegelschaltung (Q₆, Q₇; Q₁₆, Q₁₁),
jeweils an beide Seiten des Differenzverstärkers (Q₄, Q₅; Q₁₄, Q₁₅) und der ersten Stromspiegelschaltung (Q₆, Q₇; Q₁₆, Q₁₇) angeschlossenen zweiten und dritten Stromspiegelschaltungen (Q₂, Q₃, Q₈, Q₉; Q₁₂, Q₁₃, Q₁₈, Q₁₉),
wobei die ersten, zweiten und dritten Stromspiegelschaltungen (Q₆, Q₇, Q₂, Q₃, Q₈, Q₉; Q₁₆, Q₁₇, Q₁₂, Q₁₃, Q₁₈, Q₁₉) Transistoren umfassen sowie
jeweils an beide Seiten der zweiten und dritten Stromspiegelschaltungen (Q₂, Q₃, Q₈, Q₉; Q₁₂, Q₁₃, Q₁₈, Q₁₉) angeschlossenen zweiten und dritten Konstantstromquellen (I₁, Q₂, I₃, Q₁₀; I₄, Q₁₁, I₆, Q₂₀),
wobei die zweite Stromspiegelschaltung (Q₁, Q₃; Q₁₂, Q₁₃) und die zweite Konstantstromquelle (I₁, Q₁; I₄, Q₁₁) eine Steuerschaltung (Q₁, Q₂, Q₃, I₁; Q₁₁, Q₁₂, Q₁₃, I₄) bilden, damit der Transistor der an den Differenzverstärker (Q₄, Q₅; Q₁₄, Q₁₅) angeschlossenen zweiten Stromspiegelschaltung (Q₂, Q₃; Q₁₂, Q₁₃) in einem hochohmigen Eingangszustand eingeschaltet werden kann.

2. Komparator nach Anspruch 1, wobei
der Differenzverstärker (Q₄, Q₅; Q₁₄, Q₁₅) ein Paar von Transistoren (Q₄, Q₅; Q₁₄, Q₁₅) aufweist, die an den Eingangsanschluß (IN), dem ein Eingangssignal zugeführt wird, und zur Zufuhr eines Ausgangssignals an einen Ausgangsanschluß (OUT) angeschlossen sind, wobei die Basis eines (Q₄; Q₁₄) des Paars von Transistoren (Q₄, Q₅; Q₁₄, Q₁₅) an den Eingangsanschluß (IN) und der Kollektor des anderen (Q₅; Q₁₅) des Paars von Transistoren (Q₄, Q₅; Q₁₄, Q₁₅) an den Ausgangsanschluß (OUT) angeschlossen ist und
die Steuerschaltung (Q₁, Q₂, Q₃, I₁; Q₁₁, Q₁₂, Q₁₃, I₄) zur Steuerung eines auf den hochohmigen Zustand des Eingangsanschlusses (IN) ansprechenden Potentials des Eingangsanschlusses (IN) mit dem Eingangsanschluß (IN) verbunden ist,
wobei die dritte Stromspiegelschaltung (Q₈, Q₉; Q₁₈, Q₁₉) und die dritte Konstantstromspannungsquelle (I₃, Q₁₀; I₆, Q₂₀) eine mit der Steuerschaltung (Q₁, Q₂, Q₃, I₁; Q₁₁, Q₁₂, Q₁₃, I₄) identische und an den anderen (Q₅; Q₁₅) des an den Ausgangsanschluß (OUT) angeschlossen Paars von Transistoren (Q₄, Q₅; Q₁₄, Q₁₅) angeschlossene weitere Steuerschaltung (Q₈, Q₉, Q₁₀, I₃; Q₁₈, Q₁₉, Q₂₀, I₆) bilden.

3. Komparator nach Anspruch 1 oder 2, wobei jede der zweiten und dritten Konstantstromquellen (I₁, Q₁, I₃, Q₁₀; I₄, Q₁₁, I₆, Q₂₀) jeweils eine Stromquelle ((I₁, I₃, I₄, I₆) und einen weiteren Transistor (Q₁, Q₁₀; Q₁₁, Q₂₀) zur Zufuhr eines Stroms zu den zweiten und dritten Stromspiegelschaltungen (Q₂, Q₃, Q₈, Q₉; Q₁₂, Q₁₃, Q₁₈, ₁₉) umfaßt.

## Revendications

1. Comparateur pour mettre en/hors circuit une borne d'entrée (IN), comportant
une première source (I₂ ; I₅) de courant constant ;
un amplificateur différentiel (Q₄, Q₅ Q₁₄, Q₁₅) connecté à ladite première source (I₂ ; I₅) de courant constant ;
un premier circuit (Q₆, Q₇ ; Q₁₆, Q₁₇) en miroir de courant connecté audit amplificateur différentiel (Q₄, Q₅ ; Q₁₄, Q₁₅) ;
des deuxième et troisième circuits en miroirs de courants (Q₂, Q₃, Q₈, Q₉ ; Q₁₂, Qₗ₃, Q₁₈, Q₁₉) connectés aux deux côtés dudit amplificateur différentiel (Q₄, Q₅ ; Q₁₄, Q₁₅) et dudit premier circuit en miroir de courant (Q₆, Q₇ ; Q₁₆, Q₁₇), respectivement ;
lesdits premier, deuxième et troisième circuits en miroirs de courants (Q₆, Q₇, Q₂, Q₃, Q₈, Q₉ ; Q₁₆, Q₁₇, Q₁₂, Q₁₃, Q₁₈, Q₁₉) comprenant des transistors ; et
des deuxième et troisième sources (I₁, Q₁, I₃, Q₁₀ ; I₄, Q₁₁, I₆, Q₂₀) de courants constants connectées aux deux côtés desdits deuxième et troisième circuits en miroirs de courant (Q₂, Q₃, Q₈, Q₉ ; Q₁₂, Q₁₃; Q₁₈, Q₁₉), respectivement ;
ledit deuxième circuit (Q₂, Q₃ ; Q₁₂, Q₁₃) en miroir de courant et ladite deuxième source (I₁, Q₁ ; I₄, Q₁₁) de courant constant constituant un circuit de commande (Q₁, Q₂, Q₃, I₁ ; Q₁₁, Q₁₂, Q₁₃, I₄) pour valider le transistor dudit deuxième circuit (Q₂, Q₃, Q₁₂, Q₁₃) en miroir de courant connecté audit amplificateur différentiel (Q₄, Q₅ ; Q₁₄, Q₁₅) dans un état d'entrée à impédance haute.

2. Comparateur selon la revendication 1, dans lequel
ledit amplificateur différentiel (Q₄, Q₅ ; Q₁₄, Q₁₅) comporte deux transistors (Q₄, Q₅ ; Q₁₄, Q₁₅) connectés à ladite borne d'entrée (IN) à laquelle un signal d'entrée est appliqué et à une borne de sortie (OUT) pour fournir un signal de sortie, la base de l'un (Q₄ ; Q₁₄) desdits deux transistors (Q₄, Q₅ ; Q₁₄, Q₁₅) étant connectée à ladite borne d'entrée (IN), et le collecteur de l'autre (Q₅ ; Q₁₅) desdits transistors (Q₄, Q₅ ; Q₁₄, Q₁₅) étant connecté à ladite borne de sortie (OUT) ; et
ledit circuit de commande (Q₁, Q₂, Q₃, I₁ ; Q₁₁, Q₁₂, Q₁₃, I₄) est connecté à ladite borne d'entrée (IN) pour commander le potentiel de ladite borne d'entrée (IN) en réponse à un état d'impédance haute de ladite borne d'entrée (IN) ;
ledit troisième circuit (Q₈, Q₉ ; Q₁₈, Q₁₉) en miroir de courant et ladite troisième source (I₃, Q₁₀ ; I₆, Q₂₀) de courant constant constituant un autre circuit de commande (Q₈, Q₉, Q₁₀, I₃ ; Q₁₈, Q₁₉, Q₂₀, I₆) identique audit circuit de commande (Q₁, Q₂, Q₃, I₁ ; Q₁₁, Q₁₂, Q₁₃, I₄), et étant connecté audit autre (Q₅ ; Q₁₅) desdits deux transistors (Q₄, Q₅ ; Q₁₄, Q₁₅) connectés à ladite borne de sortie (OUT) .

3. Comparateur selon la revendication 1 ou 2, dans lequel chacune desdites deuxième et troisième sources (I₁, Q₁, I₃, Q₁₀ ; I₄, Q₁₁, I₆, Q₂₀) de courants constants comprend une source de courant (I₁, I₃ ; I₄, I₆) et un autre transistor (Q₁, Q₁₀ ; Q₁₁, Q₂₀) pour fournir un courant auxdits deuxième et troisième circuits (Q₂, Q₃, Q₈, Q₉ ; Q₁₂, Qₗ₃, Q₁₈, Q₁₉) en miroirs à courants, respectivement.
